## Europäisches Patentamt
## European Patent Office
## Office européen des brevets

(11) Veröffentlichungsnummer: **0 029 900**
**B1**

(12) **EUROPÄISCHE PATENTSCHRIFT**

(45) Veröffentlichungstag der Patentschrift: **26.06.85**

(21) Anmeldenummer: **80106267.0**

(22) Anmeldetag: **15.10.80**

(51) Int. Cl.⁴: **H 01 L 29/72,** H 01 L 29/08, H 01 L 29/10, H 01 L 21/76, H 01 L 29/62, H 01 L 21/82

(54) **Als bipolarer Transistor in einem Halbleitersubstrat ausgebildetes selbstjustiertes Schaltungs- oder Bauelement und Verfahren zur Herstellung.**

(30) Priorität: **29.11.79 US 98588**

(43) Veröffentlichungstag der Anmeldung: **10.06.81 Patentblatt 81/23**

(45) Bekanntmachung des Hinweises auf die Patenterteilung: **26.06.85 Patentblatt 85/26**

(84) Benannte Vertragsstaaten: **DE FR GB IT**

(56) Entgegenhaltungen:
**FR-A-2 141 938
US-A-3 631 307
US-A-4 099 987**

**IBM TECHNICAL DISCLOSURE BULLETIN,
Band 21, Nr. 10, März 1979, Seiten 4050-4052,
New York, USA
JOURNAL OF ELECTROCHEM. SOC., Band 114,
Nr. 6, Juni 1967, Seiten 603-605,**

(73) Patentinhaber: **International Business Machines Corporation
Old Orchard Road
Armonk, N.Y. 10504 (US)**

(72) Erfinder: **Horng, Cheng Tzong
6396 Gondola Way
San Jose California 95120 (US)**
Erfinder: **Poponiak, Michael Robert
2 Stirrup Drive
Newburgh New York 12550 (US)**
Erfinder: **Rupprecht, Hans Stephan
3505 Kamhi Drive
Yorktown Heights New York 10598 (US)**
Erfinder: **Schwenker, Robert Otto
6359 Gondola Way
San Jose, California 95120 (US)**

(74) Vertreter: **Gaugel, Heinz, Dipl.-Ing.
Schönaicher Strasse 220
D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Description**

Die Erfindung bezieht sich auf ein als bipolarer Transistor auf einem Halbleitersubstrat ausgebildetes, selbstjustiertes Schaltungs- oder Bauelement gemäß dem ersten Teil des Anspruchs 1 und Verfahren zu dessen Herstellung.

Strukturen, sowie Verfahren zur Herstellung, sind an vielen Stellen beschrieben.

Die US-Patentschrift 3 600 651 zeigt sowohl übereinanderliegende Halbleiterzonen als auch monokristalline Halbleiterzonen die polykristallinen Halbleiterzonen benachbart sind.

Die US-Patentschrift 3 648 125 beschreibt Herstellungsverfahren und Anordnungen, wo eine dünne Siliciumepitaxieschicht auf einem Siliciumsubstrat gebildet ist unde die einzelnen Schaltungs- oder Halbleiterbauelemente durch dazwischenliegende Oxidation elektrisch voneinander isoliert sind, wobei die oxidierten Bereiche durch die Epitaxieschicht hindurch bis zu einem sich lateral ausbreitenden PN-Übergang verlaufen.

Die US-Patentschrift 3 873 372 bezieht sich auf Isolationsgate-Feldeffekt-Transistoren, wobei das Problem einer genauen Ausrichtung der Gateelektrode oberhalb der Kanalzone angesprochen und gelöst wird.

Die US-Patentschricht 3 904 450 ist auf eine monolithisch integrierte Halbleiterschaltung mit Zellenstruktur bezogen, wobei ein Oxid-Isolationsmuster dazu dient, zumindest teilweise das Einbringen von zwei verschiedenen Arten von Fremdatomen so zu ermöglichen, daß die Anzahl der Maskenverfahrensschritte herabgesetzt wird. Einige der so gebildeten Oxidbereiche durchdringen dabei nicht die Epitaxieschicht, so daß eine sich lateral erstreckende elektrisch leitende Bahn als Basis für einen lateralen Injektionstransistor dienen kann. Ein weiteres Muster, bestehend aus polykristallinen Siliciumzonen mit hierin enthaltenen entsprechenden Fremdatomen, dient sowohl als Diffusionsquelle als auch zum Herbeiführen von Zwischenverbindungen.

Die US-Patentschrift 3 919 005 zeigt ein zweifach diffundiertes, laterales Transistorbauelement, das unter Verwendung einer Ätzmaske hergestellt ist, um selbstjustierende Lagengenauigkeit bei Bildung der verschiedenen Transistorzonen zu gewährleisten. Die laterale Struktur besteht aus Transistorzonen, die zumindest eine im wesentlich flache Oberfläche ausweisen, wobei die Struktur zumindest eine Zone aus isolierendem Material enthält, die benachbart zur flachen Oberfläche ausgebildet ist. Dabei ist die obere Oberfläche der isolierenden Zone im wesentlichen in einer Ebene mit der Halbleiteroberfläche gelegen. Innerhalb des Halbleiters ist ein Kollektor gebildet, der ersten Bereichen sowohl der flachen Oberfläche als auch der Isolationszone benachbart ist, wohingegen der im Halbleiter gebildete Emitter zweiten Bereichen sowohl der flachen Oberfläche als auch der Isolationszone benachbart ist. Eine Basis trennt den Kollektor vom Emitter.

Die US-Patentschrift 3 947 299 beschreibt ein Verfahren zur Herstellung eines Halbleiterbauelements zur Anwendung in einer monolithisch integrierten Halbleiterschaltung, bei der eine örtlich vergrabene, isolierende Schicht als Schnittstelle eines Substrats vorgesehen ist und eine Halbleiterzone an Ort und Stelle in eine Isolationszone umgewandelt wird, die sich hinab bis zur vergrabenen Isolationszone erstreckt. Ein derartiges Verfahren ist u.a. zweckmäßig zur Bereitstellung sog. isolierender Halbleiterinseln.

Die US-Patentschrift 3 958 323 bezieht sich auf ein Verfahren zur Herstellung eines selbstjustierten IGFET-Bauelements mit polykristallinem Siliciumgate unter Anwenden dreier Maskenverfahrensschritte. Schichten aus Siliciumdioxid, polykristallinem Silicium und Siliciumnitrid werden auf die Oberfläche eines Siliciumsubstrats mit erstem Leitfähigkeitstyp niedergeschlagen. Im ersten Maskenverfahrensschritt werden Fensteröffnungen in vorgegebenen Schichtbereichen oberhalb der für Source und Drain vorgesehenen Stellen angebracht. Anschließend werden dann Source und Drain über diese Fensteröffnungen in das Substrat eingebracht. Das Herstellungsverfahren wird fortgesetz, indem eine Siliciumdioxidschicht auf die Seitenoberflächen des polykristallinen Siliciumgates, die gegenüber diesen Fensteröffnungen freiliegen, niedergeschlagen wird. Anschließend wird eine Siliciumnitridschicht über alle freiliegenden Oberflächen aufgebracht, und eine zweiter Maskenverfahrensschritt dient dazu, mittels eines Ätzvorgangs diejenigen Bereiche der Nitridschicht abzutragen, wo keine Bauelementmetallisierung in einem ersten Bereich oberhalb des Gates, in einem zweiten Bereich oberhalb der Source und in einem dritten Bereich oberhalb des Drains vorgesehen ist. Anschließend wird die polykristalline Siliciumschicht abgeätzt und von der Feldzone des Schaltungselements entfernt. Die polykristalline Siliciumschicht wird im Bereich des Gates während dieses Ätzganges mit Hilfe einer ersten Nitridschicht und der über den seitlich freiliegenden Oberflächenbereichen des Gates aufgewachsenen Siliciumdioxidschicht abgedeckt. Dann werden die Nitridschichtbereiche abgetragen, so daß mit Hilfe eines dritten und letzten Maskenverfahrensschrittes metallische Anschlüsse an Source, Drain und polykristallinem Siliciumgate angebracht werden können. Alternative Verfahrensschritte werden aufgezeigt, um Gate- und Feldoxidbereiche in eine Ebene zu bringen.

Die US-Patentschrift 3 961 999 beschreibt ein Verfahren zum Bilden vertiefter Siliciumdioxidisolation in monolithisch integrierten Halbleiterschaltungen, bei denen sich sog. Vogel-schnabel-Probleme, die mit üblichen zusammengesetzten Schichtstrukturen, gebildet aus Siliciumdioxide und Siliciumnitrid, als Masken, einhergehen, auf einem Minimum halten lassen. Eine übliche Schichtstrukturmaske, bestehende aus eine Bodenschicht aus Siliciumdioxid und einer Abdeckschicht aus Siliciumnitrid mit mehreren Fensteröffnungen zum Definieren derjenigen Bezirke im Siliciumsubstrat, die thermisch oxidiert werden

**0 029 900**

sollen, wird auf ein Siliciumsubstrataufgebracht. Fluchtend mit diesen Fensteröffnungen in dieser Schichtstrukturmaske werden dann in das Siliciumsubstrat Vertiefungen eingeätzt. Bei diesem Vorgang wird die Siliciumdioxidschicht überätzt, so daß die Fensteröffnungen in der Siliciumdioxidschicht größere laterale Abmessungen als die Fensteröffnungen in der Siliciumnitridschicht aufweisen, weil die Siliciumnitridschicht längs des Umfangs der Fensteröffnungen unterätzt ist. Eine Siliciumschicht wird in diese Vertiefungen aufgebracht, um diese unterätzten Bereiche der Siliciumnitridschicht auszufüllen. Anschließend wird dann die Struktur einem thermischen Oxidationsverfahren unterworfen, durch das Silicium innerhalb und anstoßend an die Vertiefungen oxidiert wird, so daß die in den Vertiefungen gebildeten Siliciumdioxidbereiche im wesentlichen in einer Ebene mit den nicht vertieften Bereichen im restlichen Siliciumsubstrat liegen. Aufgrund der Überschneidung und der Ablagerung von Silicium in den Vertiefungen wird so der sog. Vogelschnabel-Effekt auf einem Minimum gehalten.

Die US-Patentschrift 4 011 105 bezieht sich auf verbesserte Feldinversionseigenschaften von monolithisch integrierten Halbleiterschaltungen, die N-Kanal-MOS-Halbleiterschaltungs-oder-bauelemente enthalten. Hierzu dient ein Siliciumsubstrat, bei dem die Fremdatomkonzentration im Halbleiterblock gering ist, während örtlich die Fremdatomkonzentration an den Feldoberflächenbereichen unterhalb des Feldoxids zur Trennung aktiver Oberflächenbereiche hoch ist; und zwar in dem Gebiet, wo sich einzelen N-Kanal-MOS-Bauelemente ausbilden. Die se differentielle Dotierung zwischen Oberflächenbereichen unterhalb des Feldoxids und der aktiven Oberflächenbereiche des Substrats erfolgt durch nicht-selektives Implantieren von Borionen in die Oberfläche, so daß sich eine gleichmäßige Schicht niedrigen Widerstands ausbildet, und durch Abtragen der ausgewählten Bereiche niedrigen Widerstands, um nicht-implantierte Bereiche hohen Widerstands des Substrats freizulegen und die aktiven Bauelemente bei nichtimplantierten Substrat-Oberflächenbereichen zu bilden. Auf diese Weise läßt sich der nicht-implantierte Oberflächenbereich auf einen Zwischenwert der Konzentration dotieren, um so die Arbeitsweise zu verbessern. Das verbleibende Muster der Bereiche niedrigen Widerstands wird mit Feldoxid überzogen. Dank dieser Maßnahmen ist die Verwendung relativ billinger Substrate mit niedriger Fremdatomkonzentration zur Herstellung von monolithisch integrierten Halbleiterschaltungen mit N-Kanal-MOS Schaltungs- oder Halbleiterbauelementen mit sehr guten Betriebseigenschaften sehr leicht möglich.

US-Patentschrift 4 048 649 beschreibt eine hybride Halbleiterstruktur, enthaltend sowohl bipolare als auch unipolare Transistoren. In dieser Struktur wird ein monokristallines, P-dotiertes Siliciumhalbleitersubstrat verwendet, dessen mit einer N-Epitaxieschicht überzogener Oberflächenbereich <100>-orientierte, kristallographische Ebenen hat. Die Epitaxieschicht ist durch V-Nuten, die sich durch die Epitaxieschicht hindurch erstrecken und deren Scheitellinie innerhalb des Halbleitersubstrats verläuft, in elektrisch isolierende Bereiche aufgeteilt. Ein dünner Siliciumdioxidfilm bedeckt die Flanken der V-Nuten, die ihrerseits mit polykristallinem Silicium aufgefüllt sind. Falls es erforderlich ist, polykristallines Silicium als Isolationsgate eines Feldeffekt-Transistors zu verwenden, wird diese polykristalline Silicium elektrisch leitend ausgebildet. Die Basen der bipolaren Transistoren werden durch Eindiffundieren geeigneter Fremdatome in die betreffenden Bereiche der Epitaxieschicht ausgebildet.

Die Emitter, Drains und Sources werden durch Diffusion jeweils unterschiedlicher Fremdatome eingebracht. Jeder Feld-effekt-Transistor hat seine Drain und Source auf benachbarten Bereichen der Epitaxieschicht, die aber durch die V-Nut getrennt sind, über der dann das Gate angebracht ist. Die Basis und der Emitter eines bipolaren Transistors können auf der einen Seite der V-Nut und der Kollektor in einem benachbarten Bereich auf der anderen Seite der V-Nut angeordnet sein, die dann mit elektrisch leitendem polykristallinem Material aufgefüllt ist.

Die US-Patentschrift 4 103 415 zeigt eine zwischen polykristallinem Siliciumgate und jeweiliger Anschlußöffnung an Source oder Drain eines IGFET-Halbleiterbauelements liegende Oxidschicht, um so Kurzschlüsse zwischen Gate und jeweiligem metallischem Anschluß an Source oder Drain zu verhindern. Die dielektrische Oxidschicht gestattet es, die Anschlußöffnung extrem nahe an das polykristalline Siliciumgate heranzubringen, ohne daß Kurzschlüsse hierzwischen auftreten können, so daß keine besondere Sicherheitsanstände zwischen Gate und Anschlußöffnungen vorgesehen zu werden brauchen.

Der Inhalt der britischen Patentschrift 1 514 624 läßt sich folgendermaßen zusammenfassen:

Bei integrierten Halbleiterschaltungen mit bipolaren Schaltungs- oder Bauelementen sind üblicherweise Isolationszonen hierzwischen dergestalt vorgesehen, daß spezielle Isolationsdiffusionszonen eingebracht werden.

Eine monolithisch integrierte Halbleiterschaltung dieser Art läßt sich z.B. herstellen, indem zunächst auf ein P-Halbleitersubstrat eine N-leitende Epitaxieschicht auf demjenigen Oberflächenbereich angebracht wird, auf dem anschließend eine Oxidschicht gebildet werden soll. Übliche photolithographische Verfahrensschritte dienen dann dazu, eine rahmenförmige Struktur untereinander verbundener Fensteröffnungen in diese Oxidschicht einzuätzen, um hierüber eine P-Diffusion bis zu einer solchen Substrattiefe durchzuführen, bei de die Diffusionsfront die Konzentration der P-Fremdatome im Substrat ünerlappt. Auf diese Weise ergeben sich N-dotierte Halbleiterzonen, die vollständig von einem P-N-Übergang eingeschlossen sind. Wenn das P-dotierte Substrat und die $P^+$-dotierten Isolationsrahmen an ein Potential mit dem höchsten negativen Wert angeschlossen werden, dann sind somit alle Isolations-P-N-Übergänge in Sperrichtung vorgespannt. Eine tiefe eindringende Diffusion dieser Art läßt unvermeidlich eine laterale Diffusion bis zu einem gewissen Ausmaß unterhalb der Oxidmaske eintreten, so daß die betreffenden Zonen der Schaltungselemente in der monolithisch integrierten Halbleiterschaltung, z.B. die P-dotierten

3

Basiszonen eines N-P-N-Transistors, die innerhalb dieser Isolationszonen liegen, vorsorglich in einem gewisen Abstand von den P-dotierten Isolationszonen zu liegen kommen müssen. Dieser Sicherheitsabstand ergibt sich aus Diffusionstiefen, Justierungstoleranzen und Platzerfordernissen für z.B. einen Transistor und hängt außerdem in großem Maße vom Platzbedarf für Isolationszwecke ab.

Um diese Nachteile zu umgehen, wird zur sog. Isoplanar-Technik übergegangen, bei de eine dünne Siliciumnitridschicht auf die Oberfläche einer Siliciumepitaxieschicht aufgebracht wird, um dann die angestrebte Struktur in bekannter Weise einzuätzen. Verbleibende Bereiche der Siliciumnitridschicht dienen als Maske zum Ätzen einer rahmenartigen Nutstruktur in die Epitaxieschicht bei einer Ätztiefe von angenähert der halben Dicke dieser Epitaxieschicht. Während eines anschließenden Oxidationsverfahrensschrittes wird das in den geätzten Nuten freigelegte Silicium örtlich in Siliciumdioxid verwandelt, wobei die unterhalb der verbliebenden Bereiche der Siliciumnitridschicht liegenden Zonen unverändert beibehalten bleiben, da die Siliciumnitridschicht gegenüber dem Oxidationsvorgang eine Maskenwirkung aufweist. Dieser Oxidationsvorgang wird fortgesetzt, bis die Grenze des so gebildeten Oxids den N-P-N-Übergang zwischen Epitaxieschicht und Substrat überschritten hat. Als Resultat ergibt sich, daß unterhalb der verbliebenden Siliciumnitrid-Schichtbereiche Siliciuminseln beibehalten bleiben, die gegenüber dem Substrat durch einen P-N-Übergang isoliert sind und jeweils isolierende Oxidrahmen als laterale Grenzen besitzen.

Der gegenwärtige Trend in der Halbleitertechnik geht dahin, höchstmögliche Packungsdichten bei hohen Arbeitsgeschwindigkeiten und geringstem Leistungsbedarf der monolithisch integrierten Halbleiterschlatungen bereitzustellen. Als wesentlicher Parameter für derart hohe Anforderungen an bipolaren Transistoren ist der Streukapazitätseffekt zu nennen, welcher sich dadurch niedrig halten läßt, daß erstens eine möglichst flach verlaufende vertikale Halbleiterzonenstruktur und zweitens eine möglichst geringe Horizontalausdehnung bei einem Schaltungs- oder Bauelement angestrebt werden, Dies erfordert natürlich, daß Schaltungs- oder Bauelemente in monolithisch integrierten Halbleiterschaltungen so klein wie möglich gehalten werden.

Mit fortschreitenden Verbesserungen in der Halbleiterverfahrenstechnik, wie z.B. durch Ionenimplantation, dielektrische Tiefenisolation, Elektronenstrahl- und Röntgenstrahllithographie, reaktives Ionenätzen, zweckmäßige Isolations- und Polykristallinsiliciun-Niederschlagsverfahren sowie Metallabtragungsverfahren, läßt sich heutzutage die Herstellung von monolithisch integrierten Halbleiterschaltungen mit sehr guten Betriebseigenschaften durchführen.

Die Ionenimplantation stellt Mittel zur genauen Einhaltung des Gesamtbetrags von auf eine Halbleiterscheibe zu übertragenden Fremdatomen bereit. Die Fremdatomtiefenverteilung im Halbleiter läßt sich dabei präzis durch Einstellen der Implantationsenergie steuern. Gegenüber üblichen thermischen Diffusionsverfahrensschritten stellt zudem noch die Ionenimplantation keinen Hochtemperaturprozeß dar. Durch Anwenden einer Photolack- oder Metallmaske können Vielfachoperationen zum Einbringen von Fremdatomen ohne Zuhilfenahme hoher Temperaturen ausgeführt werden. Abschließend vorgenommene thermische Diffusionseintreibung reicht aus, die beim Implantationsvorgang aufgetretenen Strahlungsschäden auszugleichen und gleichzeiting die angestrebte Tiefe des P-N-Übergangs zu erhalten. Infolgedessen lassen sich so monolithisch integrierte Halbleiterschaltungen bereitstellen, die flachliegende Schaltungs- oder Bauelemente hinzukommend mit größerer Präzision in der Fremdatomverteilung aufweisen.

Mit der Forderung nach immer flacher liegenden Schaltungsoder Bauelementen wird zudem eine Verringerung der P-N-Übergangs-Gesamtflächen angestrebt, so daß sich entsprechend die Streukapazitäten herabsetzen lassen. Die Verminderung von Streukapazitäten läßt sich durch kleinere Horizontalabmessungen der Schaltungs- oder Bauelemente und durch Verwenden dielektrischer Isolation herbeiführen. Eine dielektrische Isolation in monolithisch integrierten Halbleiterschaltungen vermeidet bei Schaltungs- oder Bauelementen besondere Isolationszonen mit P-N-Übergängen. Bekannte dielektrische Isolationsmaßnahmen beruhen auf einer in Vertiefungen eingebrachten Oxidisolation. Unter Verwenden von Siliciumnitrid als Oxidationsbarriere wird hierbei so vorgegangen, daß Nuten in einen Halbleiterwafer eingeätzt werden, um Halbleiterbereiche, in die P-N-Übergänge eingebracht werden sollen, voneinander zu isoliern. In diesen Nuten freigelegtes Silicium wird thermisch oxidiert, so daß sich mit Oxid angefüllte Vertiefungen bilden, die dielektrische Isolationszonen darstellen. Als unerwünschtes Ergebnis dieses Verfahrensganges jedoch zeigt sich die Bildung sog. Vogelkopf- und Vogelschnabelstrukturen an seitlichen Rändern der Oxidvertiefung. Derartige Strukturen sind aber unerwünscht, weil sie zu Brüchen oder Diskontinuitäten in Dünnfilmen führen können, die über diese Unstetigkeitsstellen zu liegen kommen. Die mit einer derartigen Vogelschnabelstruktur darüber hinaus einhergehende Lagenunbestimmtheit führt zudem indirekt zur Verminderung des zur Verfügung stehenden Flächenbereichs, da bei Auslegungsplanung einer monolithisch integrierten Halbleiterschaltung vorsorglich entsprechende Abmessungsschwankungen einkalkuliert werden müssen, also lateral entsprechend große Toleranzen zuzulassen sind.

Die neuerdings entwickelte Oxidisolation in Form der sog. dielektrischen Tiefenisolation umgeht oben genannte Probleme. Beim hiermit verbundenen Verfahren wird reaktives Ionenätzen angewendet, um in Halbleiterscheiben tiefe, enge Nuten einzubringen, die jeweils Gebiete mit Schaltungs- oder Bauelementen umgeben. Hierzu wird auf die USA-Patentschriften 4 104 085 und 4 139 442 verwiesen. Mittels chemischen Niederschlags asu der Dampfphase werden diese Nuten dann mit Siliciumdioxid aufgefüllt. Nach Abschluß diese Verfahrensganges ist dann die Halbleiterstrukturoberfläche wieder vollkommen eben. Seitliches

reaktives Ionenätzen bis zur Halbleiteroberfläche führt zu tiefen Oxidations-Isolationsnuten. Anders wie beim Vogelschabeleffekt sind die Seitenwände bei derartigen dielektrischen tiefen Isolationsstrukturen nahezu vertikal. Die Oberfläche dieser dielektrischen Tiefenisolationsgebiete und die die Schaltungs- und/oder Halbleiterbauelemente enthaltenden Siliciumbereiche liegen auch wieder in einer Ebene. Der bei dielektrischer Tiefenisolation angewendete Dotierungsverfahrensgang für die verschiedenen Schaltungs- oder Halbleiterbauelementbereiche ist dann dank der Oxidisolation selbstjustierend. Ein derartiger selbstjustierender Verfahrensgang erübrigt das Anwenden präziser Maskenausrichtungs-Verfahrensschritte und spart außerdem eine Anzahl von Maskenverfahrensschritten bei Herstellung von monolithisch integrierten Halbleiterschaltungen ein.

Bei allen oben genannten Verfahren jedoch ist es üblich, Basisanschlüsse der bipolaren Transistoren im inaktiven Bereich oberhalb der die Emitterzone umgebenden Basiszone anzubringen. Die so tatsächlich benötigte Transistorbasiszone, um sowohl Emitterzone als auch Basisanschluß anzubringen, muß deshalb beträchtlich größer sein als die eigentlich aktive Basiszonenfläche. Dies führt aber zu nicht zu vernachlässigenden Kollektorbasis-Streukapazitäten, was seinerseits wiederum das Betriebsverhalten eine derartigen Transistors nachteilig beeinflussen kann, so daß hierdurch einer Verwendung Grenzen gesetzt sind. Dies gilt insbesondere für Betriebsgeschwindigkeiten, deren Erhöhung in modernen Rechenanlagen ständig angestrebt wird.

Bei dieser Sachlage besteht die Aufgabe der Erfindung darin, zur Bereitstellung von Transistorstrukturen in monolithisch integrierten Halbleiterschaltungen mit sehr guten Betriebsverhalten, insbesondere zur Erzielung größtmöglicher Arbeitsgeschwindigkeiten, möglichst kleine Basiszonenflächen unter Ausschaltung inaktiver Bereiche vorzusehen; wobei bei bipolaren Transistoren als aktiver Basisbereich derjenige anzusehen ist, der der Emitterzone unmittelbar benachbart ist.

Die Erfindung, wie sie in den Ansprüchen gekennzeichnet ist, löst diese Aufgabe dadurch, daß bei streng vertikalen Transistoraufblau, bedingt durch ausschließlich übereinanderliegende Transistorzonen mit im wesentlichen planaren und gleichmäßig voneinander beabstandeten P-N-Übergangsflächen von etwa 1 µm² vorgesehen sind, so daß der Basisanschluß nur lateral, und nicht wie üblich an der Oberfläche der monolithisch integrierten Halbleiterschaltung, anzubringen ist. Das zur Herstellung eines derartigen Transistors in einer monolithisch integrierten Halbleiterschaltung angewendete Verfahren beruht auf einem selbstjustierenden Prozeß. Neben sehr geringen lateralen Abmessungen so hergestellter Transistoren liegen außerdem noch sehr kleine Dimensionen in vertikaler Richtung vor. Der Schaltungs- oder Bauelementbereich ist in der monolithisch integrierten Schaltungsanordnung erfindungsgemäß von einer tiefreichenden mit Oxid gefüllten Nut umgeben, wobei nahezu vertikale Seitenwandungen vorliegen. Diese Tiefennut erstreckt sich von der Siliciumepitaxieoberfläche über eine vergrabene, beispielsweise N⁺-Kollektorzone bis hinab in das P-leitende Halbleitersubstrat. Die Tiefennutbreite beträgt beispielsweise etwa 2 µm bis 3 µm. Zur Einhaltung eines zweckentsprechenden Abstandes des Emitteranschlusses vom Kollektoranschluß ist eine flachliegende, mit Oxid ausgefüllte Nut vorgesehen, die sich von der Siliciumepitaxieoberfläche bis in den oberen Bereich des vergrabenen N⁺-Kollektors erstreckt, wohingegen in lateraler Hinsicht deren Grenzen durch die Transistorstruktur und den Kollektoranschluß-Oberflächenbereich festgelegt ist. Die Oberflächen der Isolationsbereiche und der Siliciumbereiche, worin sich die Transistoren befinden, liegen dabei in einer Ebene.

Dank der Erfindung wird erreicht, daß die Oberfläche der Basiszone nur geringfügig größer ist als die der Emitterzone, so daß sich nur sehr kleine Kollektor-Basiskapazitäten ergeben und damit ein äußerst gutes Betriebsverhalten so hergestellter Transistoren zu verzeichnen ist.

Der Anschluß an die Transistorbasis wird in vorteilhafter Weiterbildung der Erfindung mittels einer stark mit Bor dotierten polykristallinen Siliciumdickschicht herbeigeführt, die die Emitter- und Basiszone umgibt, wobei der Kontakt über der gesamten Umfangfläche der Basiszone vorliegt. Die P⁺-polykristalline Siliciumdickschicht, die so einen sehr geringen Basiswiderstand gewährleistet, liegt innerhalb der Oxidisolationsnuten, do daß zusätzlich noch die Streukapazitäten auf ein absolutes Minimum herabgesetzt sind. Die aktive Transistorbasiszone wird an Ort und Stelle mittels Borionenimplantation schwacher Dosierung hergestellt, wobei das Fremdatom-Konzentrationsmaximum unterhalb der Emitterzone zu liegen kommt. Ein derart gebildetes Schaltungs- oder Halbleiterbauelement besitzt eine einstellbar geringe Basisbreite bei sehr geringem äußeren Basiswiderstand. Diese beiden Eigenschaften sind aber erforderlich, um Schaltungs- oder Bauelemente für hohe Arbeitsgeschwindigkeiten herzustellen.

Die Emitterzone im erfindungsgemäß hergestellten Transistor ist gegenüber der sie umbebenden P⁺-dotierten polykristallinen Siliciumdickschicht durch eine dielektrische Doppelschicht, bestehend aus Siliciumnitrid und Siliciumdioxid, isoliert. Eine derartige dielektrische Isolation stellt sicher, daß in die Basiszone injizierte Elektronen nur über die Bodenfläche der Emitterzone zur Einwirkung gelangen können. Eine so gebildete dielektrische Emitterhülse verhindert außerdem eine durch ihre Seitenwandung nach außen gerichteten Löcherstrom, der bei bisher vorhandenen Transistoren ohne weiteres nicht zu vermeiden ist. Das bedeutet aber, daß gemäß der Erfindung hergestellte bipolare Transistoren einen hohen Emitterinjektionswirkungsgrad und zudem noch hohe Transistorstromverstärkung zeigen.

Ein weiterer Vorteil ergibt sich auch noch aus den geringen Strukturabmessungen bei vollkommen ebenen Zonenoberflächen, so daß hierüber vorzusehende Schutzfilmüberzüge bezüglich ihrer Haftfähigkeit keinerlei Probleme bilden können. Nicht zuletzt ergibt sich dank der Erfindung noch der Vorteil, daß die Transistorzonenanschlüsse relativ weit auseinander liegen und somit ebenfalls vor Herabsetzung der Streukapazitäten beitragen.

Im folgenden wird die Erfindung sowie das hierzu anzuwendende Herstellungsverfahren anhand von lediglich einen Ausführungsweg darstellenden Ziechnungen näher erläutert.

Es zeigen:

Fig. 1A eine Draufsicht auf eine Transistorstruktur gemäß der Erfindung als Ausschnitt aus einer monolithisch integrierten Halbleiterschaltung,

Fig. 1B einen ausschnittsweisen Querschnitt längs der Linie 1B—1B in Fig. 1A,

Fig. 1C einen ausschnittsweisen Querschnitt längs der Linie 1C—1C in der Fig. 1A,

Fig. 2 bis 21 ausschnittsweise Querschnitte, die eine erfindungsgemäß herzustellende Struktur in den verschiedenen Verfahrensabschnitten andeuten.

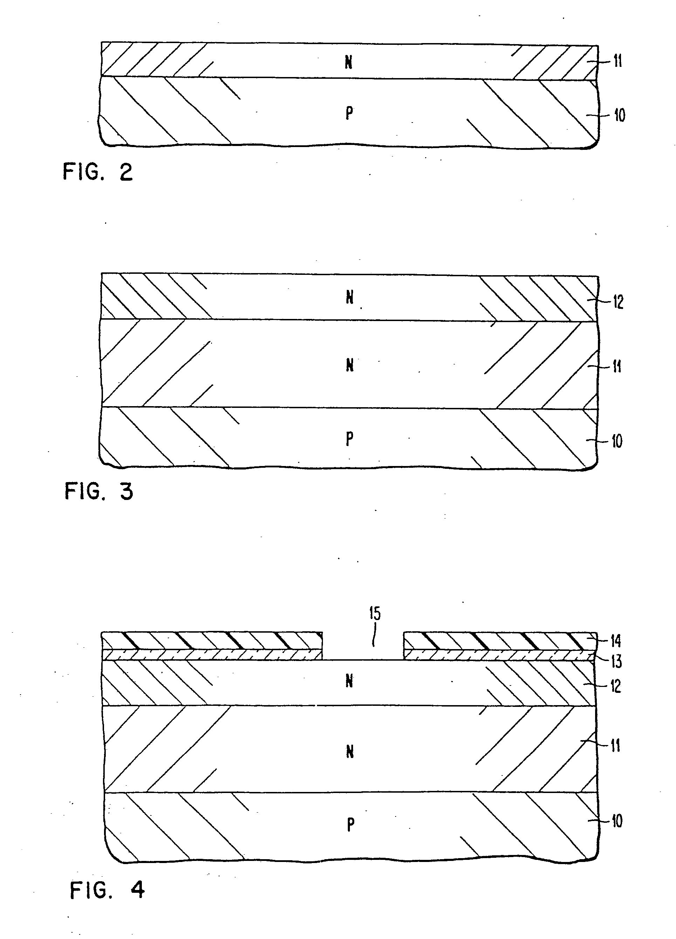

Wie der Fig. 2 zu entnehmen, wird von einem P-leitenden monokristallinen Siliciumhalbleiter 10 als Halbleitersubstrat ausgegangen. Zur Bereitstellung der vorgesehenen vergrabenen Kollektorzone 11 werden zwecks Herbeiführen einer entspechenden N-Zone geeignete Fremdatome in das Halbleitersubstrat 10 eingebracht. Hierzu kann z.B. Arsen in an sich bekannter Weise eingebracht werden, sei es durch Diffusion oder Ionenimplantation. Der Quadratflächenwiderstand dieser N-Kollektorzone 11 liegt bei etwa 0,001 Ω cm. Wie aus Fig. 3 ersichtlich, wird auf die freie Oberfläche der Kollektorzone 11 eine N-leitende Siliciumepitaxieschicht 12 mit einer Dicke von etwa 1,0 µm bis 1,5 µm aufgebracht. Während dieses bei hohen Temperaturen vorgenommenen Epitaxieverfahrensschrittes diffundiert die Kollektorzone 11 nach oben in die Epitaxieschicht 12 aus. Der Quadratflächenwiderstand der Epitaxieschicht liegt bei etwa 0,3 Ω cm. Wie in Fig. 4 angedeutet ist eine Oxidschicht 13 vorzugsweise unter Anwenden chemischen Verdampfungsniederschlags in einer Dicke von etwa 300 nm auf die freie Oberfläche der Epitaxieschicht 12 aufgebracht. Auf die freie Oberfläche der Oxidschicht 13 wird eine Photolackschicht 14 aufgetragen, die aufeinanderfolgend exponiert und entwickelt wird, um eine Fensteröffnung 15 an derjenigen Stelle der Oberfläche anzubringen, bei der ein einzubringender flachliegender dielektrischer Isolationsgraben eingebracht werden soll. Die Photolackschicht 14 dient dabei als Maske zum reaktiven Ionenätzen der Oxidschicht 13, die z.B. aus Siliciumdioxid besteht. Der Ätzvorgang wird abgebrochen, sobald die obere Oberfläche der Epitaxieschicht 12 erreicht ist. Danach wird die Photolackschicht 14 wieder abgezogen.

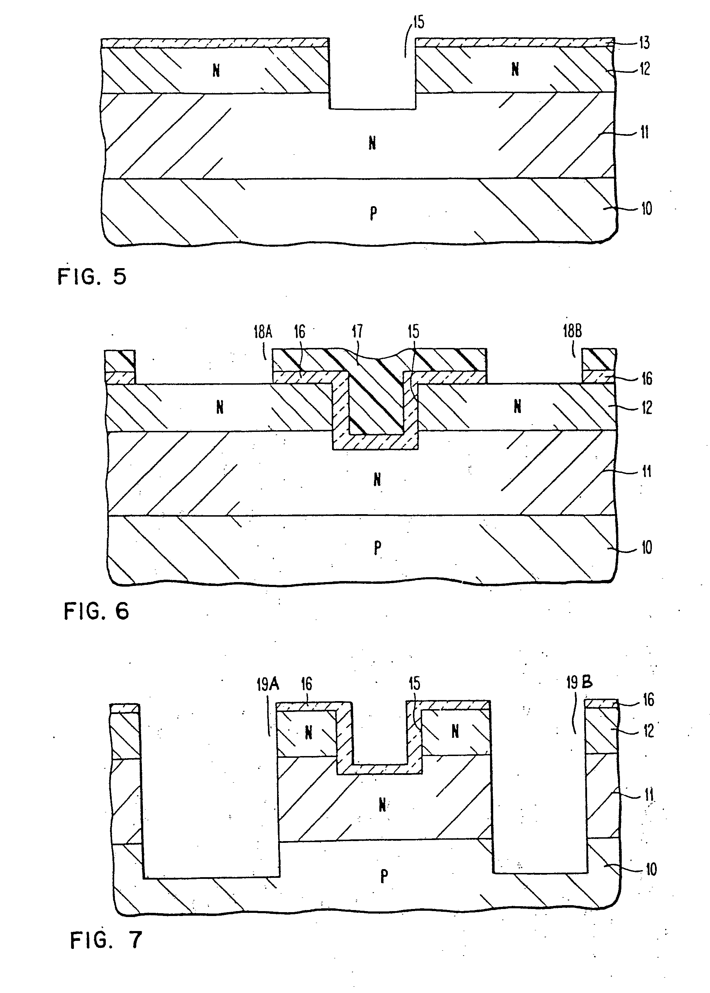

Beim mit Fig. 5 zusammenhängenden Verfahrensgang dient die Oxidschicht 13 als Ätzmaske, um das in der Fensteröffnung 15 freigelegte Silicium unter Anwenden reaktiven Ionenätzens abzutragen. Der Ätzgang wird gestoppt, sobald sich eine Vertiefung in der $N^+$-dotierten Kollektorzone 11 zeigt. Die als Maske benutzte Oxidschicht 13 wird mit Hilfe einer chemischen Lösung, z.B. einer gepufferten Fluor-Wasserstofflösung, abgetragen.

Die in Fig. 6 gezeigte Struktur ergibt sich, wenn auf die Struktur nach Fig. 5 zunächst unter Anwenden eines chemischen Verdampfungsvorgangs eine Oxidschicht 16 mit einer Dicke von etwa 600 bis 700 nm auf die freigelegte Oberfläche der Epitaxieschicht 12 sowie die Wandungen und den Boden des Isolationsgrabens 15 aufgebracht wird. Hierüber muß noch eine Photolackschicht 17 aufgetragen werden die anschließend exponiert und entwickelt wird, um die Fensteröffnungen 18A und 18B zu erhalten, die an denjenigen Stellen der Oberfläche zu liegen kommen, wo tiefreichende Isolationsgräben einzubringen sind. Die Photolackschicht 17 dient als Maske für das reaktive Ionenätzen der Oxidschicht 16. Der Ätzvorgang wird abgebrochen, sobald die Epitaxieschicht 12 erreicht ist. Dann wird die Photolackschicht 17 abgezogen. Unter Verwenden der Oxidschicht 16 als Ätzmaske wird das in das Fensteröffnungen 18A und 18B freigelegte Silicium einer reaktiven Ionenätzung unterworfen.

Wie sich aus Fig. 7 ergibt, wird der Ätzvorgang abgebrochen, sobald nach Durchdringen der Epitaxieschicht 12 in der Kollektorzone 11 eine Vertiefung im P-Halbleitersubstrat 10 entstanden ist, so daß sich tiefreichende Isolationsgräben 19A und 19B ergeben, deren Tiefe angenähert 4—5 µm beträgt. Die als Maske benutze Oxidschicht 16 wird dann wieder abgezogen.

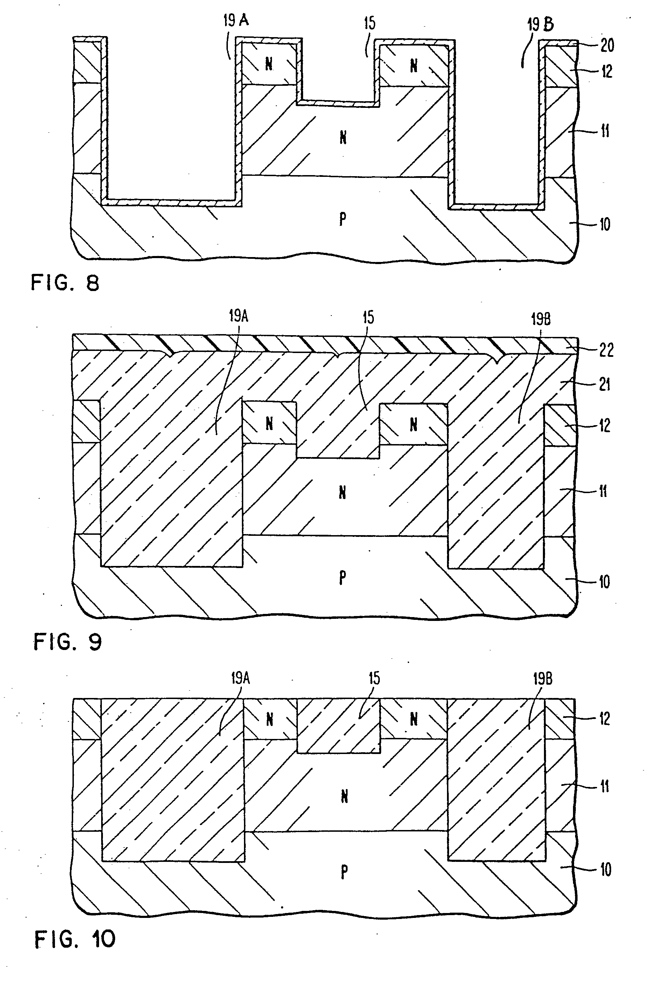

Um die in Fig. 8 gezeigte Struktur zu erhalten, wird die sich nach dem letzten Verfahrensgang ergebende Struktur in den gezeigten Oberflächenbereichen thermisch oxidiert, so daß sich über den Grabenwandungen, den Grabenböden und den freien Halbleiteroberflächen eine Oxidschicht 20 bildet, deren Dicke etwa 100 bis 200 nm beträgt.

Im Anschluß daran wird eine Oxiddickschicht 21 mit Hilfe eines chemischen Verdampfungsverfahrens aufgebracht, so daß wie in Fig. 9 gezeigt der flachliegende Isolationsgraben 15, sowie die tiefliegenden Isolationsgräben 19A und 19B mit Oxid aufgefüllt werden. Bei 3 µm tiefen Isolationsgräben ist zur Auffüllung eine entsprechende Oxidschichtstärke erforderlich. Wie in Fig. 9 angedeutet, können sich oberhalb der aufgefüllten Isolationsgräben 19A, 19B, 15, jeweils in deren Mitte, noch Einbuchtungen zeigen. In diesen Falle ließe sich eine Photolackschicht 22 auf die freie Oberfläche auftragen, um unter Anwenden geeigneter Verfahrensschritte die Oberfläche der Oxidschicht 12 einzuebnen. Dies läßt sich unter Anwenden von reaktivem Ionenätzen auf Photolackschicht 22, sowie Oxidschicht 21 durchführen. Hierbei ist es in erster Linie bedeutsam, daß die Ätzrate beim reaktiven Ionenätzen des Photolacks nahezu gleich der des reaktiven Ionenätzens der Siliciumdioxidschicht ist. Damit wird erreicht, daß bei gleicher Dicke des Photolacks und des Siliciumdioxids an allen Stellen der Halbleiterscheibe das Abätzen bis zum Silicium zu einer planaren Oberfläche, wie in Fig. 10 gezeicht, führt, wobei die Isolationsgräben 19A, 19B und 15 aufgefüllt sind.

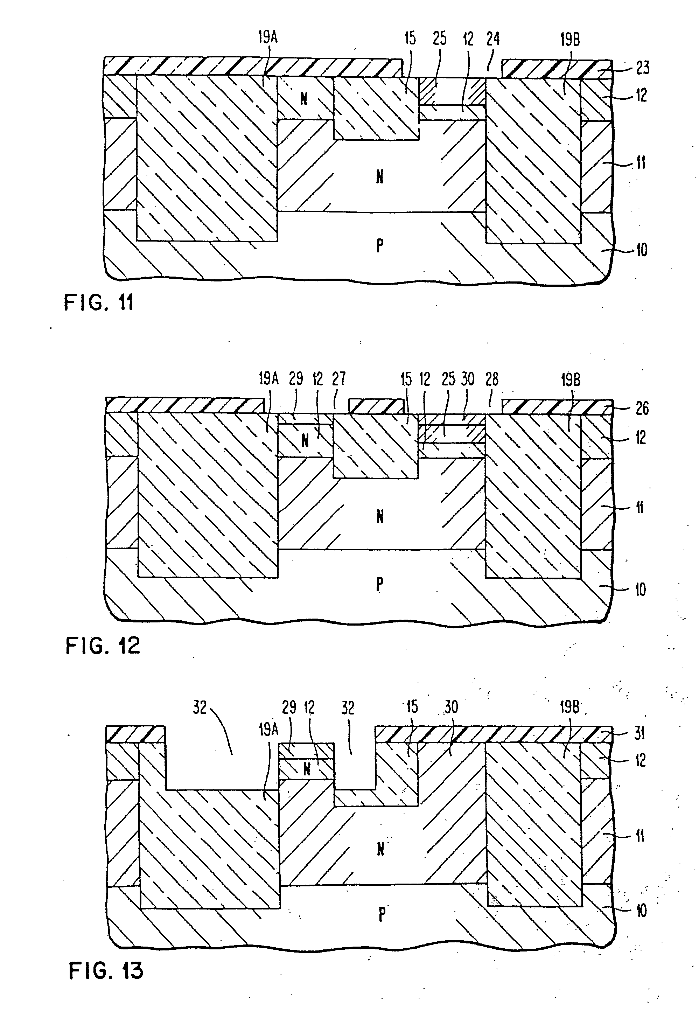

In Fig. 11 ist eine Photolackmaske 23 auf der Halbleiterscheibenoberfläche aufgebracht, indem unter Exponieren und Entwickeln eine entsprechende Fensteröffnung 24 eingebracht wird. Über diese Fensteröffnung wird durch Ionenimplantation eine N-Fremdatomdotierung, beispielsweise Phosphor, in Epitaxieschicht 12 vorgenommen, um hieren die Durchreichzone 25 auszubilden, Anschließend wird die Photolackschicht 23 wieder abgezogen.

Die in Fig. 12 gezeigte Struktur ergibt sich, wenn erneut eine Photolackschicht 26 aufgetragen wird, die anschließend exponiert und entwickelt wird, um hierin wiederum Fensteröffnungen 27 und 28 einzubringen, über die mittels Arsenionenimplantation Emitter 29 und Kollektoranschlußzone 30 gebildet werden. Die Arsenionenimplantation läßt sich als Beispiel mit einer Intensität in der Größenordnung von 40 bit 50 keV und eine Dosierung im Bereich zwischen 2,0 bis $4,0 \times 10^{15}$ Ionen pro $cm^2$ durchführen. Hiernach wird die Photolackschicht 26 abgezogen, um dann die Struktur aufzuheizen, so daß sowohl die Emitterzone 29 eingetrieben und die Kollektoranschlußzone 30 in Epitaxieschicht 12 gebildet wird.

Wie Fig. 13 zeigt, befindet sich erneut eine Photolackschicht 31 auf der Halbleiterscheibe, die nach Exponieren und Entwickeln zum Freilegen der Fensteröffnungen 32 die vorgesehene Zone für den polykristallinen Siliciumbasiskontakt definiert. Die über die Photolackmaske 31 freigelegten Oxidbereiche werden mit Hilfe einer gepufferten Fluor-Wasser-stofflösung oder durch reaktives Ionenätzen abgetragen, wobei eine sehr niedrige Siliciumätzrate vorgesehen ist. Die Oxidätzung wird abgebrochen, sobald das Niveau der oberen Oberfläche der vergrabenen $N^+$-Kollektorzone unterschritten ist. Hiernach wird die Photolackschicht 31 abgezogen.

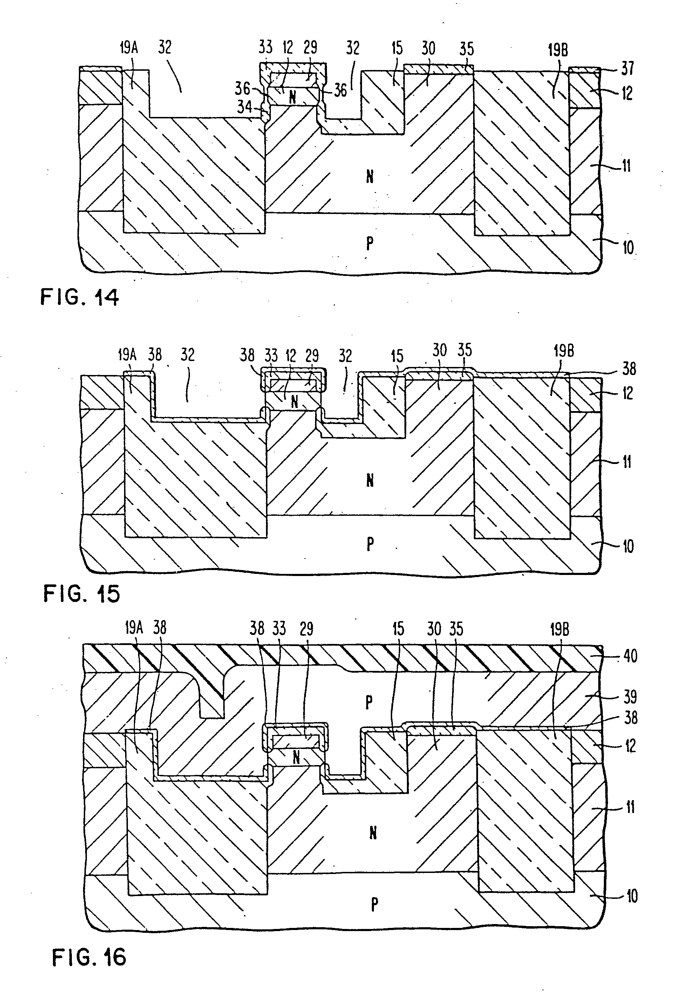

Die in Figur 14 gezeigte Struktur ist bei relativ niedriger Temperatur, vorzugsweise zwischen 800 und 850°C, thermisch oxidiert, so daß sich eine Oxidschicht über den freigelegten.

Siliciumbereichen gebildet hat. Diese Niedrigtemperaturoxidation führt zur Bildung von Dickoxidschichten 33, 34 und 35 über dem entartet dotierten Emitter 29, die vergrabenen Kollektorzone 11 und der Kollektoranschlußzone 30. Diese Niedrigtemperaturoxidation bildet außerdem dünne Oxidschichten 36 und 37 auf den Seitenwandungen des niedrig dotierten Basisanschlusses und der Oberfläche der Epitaxieschicht 12. So betragen z.B. bie einer Naßoxidation mit 850°C die aufgewachsenen Oxidschichtdicken auf dem entartet und leicht N-dotierten Silicium 200 nm bzw. 50 nm. Die oxidierte Halbleiterscheibe wird dann einem Ätzvorgang unter Einwirken eine chemischen Lösung wie z.B. einer gepufferten Fluor-Wasserstofflösung ausgesetzt, und zwar für einen Zeitraum, der ausreichend ist, um die Oxiddünnschichten 36 und 37 zwar abzutragen, jedoch nicht ausreicht, um die Oxiddickschichten 33, 34 und 35 gänzlich abzutragen.

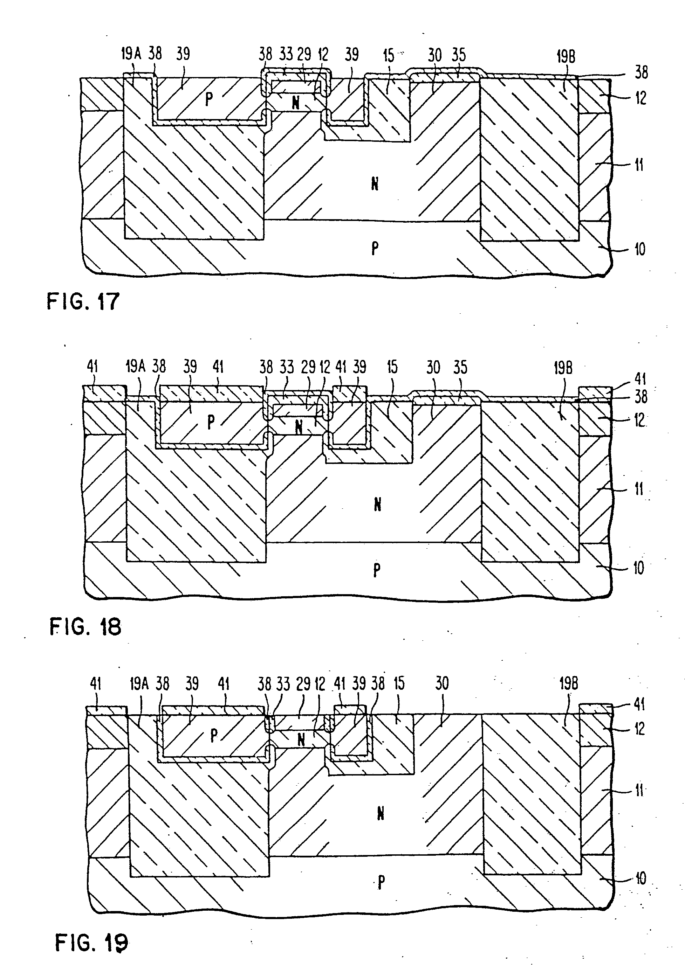

Aus Fig. 15 ergibt sich, daß eine Siliciumnitridschicht ($Si_3N_4$) 38 auf bestimmten Oberflächenbereichen mit einer Dicke von etwa 100 nm vorliegt, wobei die Auftragung unter Anwenden eines chemischen Verdampfungsverfahrens stattgefunden hat. Die so neidergeschlagene Siliciumnitridschicht 38 ist koplanar mit der Schaltungs- oder Bauelementstruktur. Durch Anwenden eines Anodisierungsverfahrens, wie es von P. F. Schmitt und D. R. Wonsidler unter dem Titel "Conversion of $Si_3N_4$ Films to Anodic $SiO_2$", in "J. Electro-Chemical Soc." Seiten 603—605 (1967) beschrieben ist, wird die auf die freigelegten Siliciumbereiche 12 und 36 niedergeschlagen Siliciumnitridschicht in anodisches Siliciumdioxid umgewandelt. Hierbei findet jedoch nicht eine Umwandlung der Siliciumnitridschicht auf den Oxidschichten 15, 19, 33, 34 und 35 durch Anodisieren statt. Die anodisch gebildete Siliciumdioxidschicht wird dann durch Anwenden einer gepufferten Fluor-Wasserstofflösung abgetragen.

Wie in Fig. 16 gezeigt, ist eine stark dotierte polykristalline P-Siliciumschicht 39 auf die freiliegende Oberfläche aufgebracht. Die polykristalline Siliciumschicht 30 läßt sich vorzugsweise durch Anwenden eines chemischen Niederdruckdampfverfahrens bilden, so daß sich eine gute Dickengleichmäßigkeit ergibt. Das Dotieren der polykristallinen Siliciumschicht 39 wird an Ort und Stelle während der Durchführung des chemischen Aufdampfverfahrensganges vorgenommen. Alternativ läßt sich eigenleitendes polykristallines Silicium auftragen, um dann durch Borionenimplantation die Dotierung vorzunehmen. Eine abdeckende Photolackschicht 40 wird anschließend aufgetragen, um dann in geeigneter Weise die polykristalline Siliciumschicht 39 einebnen zu können. Im hierzu erforderlichen Verfahrensgang wird unter Anwenden von reaktivem Ionenätzen die Photolackschicht 40 abgetragen und die polykristalline Siliciumschicht 30 entsprechend verdünnt. Die Ätzrate beim reaktiven Ionenätzen der Photolackschicht ist vorzugsweise gleich der für polykristallines Silicium.

Wie aus Fig. 17 hervorgeht, wird das reaktive Ionenätzen abgebrochen, sobald die Oberfläche der Siliciumnitridschicht 38 erreicht ist.

Das Herstellungsverfahren wird fortgeführt, indem eine thermische Oxidation vorgenommen wird, um eine relativ dicke Oxidschicht 41 auf die freigelegte polykristalline Siliciumschicht 39 und die Epitaxieschicht 12 aufzutragen. Die Dicke der Oxidschicht 41 sollte sehr viel dicker als die auf die Emitterzone 29 aufgetragenen Oxidschicht 33 sein. Um das Ausdiffundieren von P-leitenden Fremdatomen aus der polykristallinen Siliciumschicht 39 in die Epitaxieschicht 12 während des Oxidwachstums auf ein Mindestmaß herabzudrücken, wird vorzugsweise ein Hochdruckoxidationsverfahren angewendet. Anschießend wird die Siliciumnitridschicht 38 durch Anwenden einer heißen Phosphorsäure ($H_3PO_4$) wieder abgetragen.

Die Oxidschicht 33 bzw. 35 auf der Emitterzone 29 und der Kollektoranschlußzone 30 werden dann mittels reaktiven Ionenätzens abgetragen, wobei eine sehr niedrige Ätzrate für Silicium vorliegt. Diese Oxidationssätzung wird abgebrochen, sobald das darunterliegende Silicium erreicht ist. Wie Fig. 19 zeigt, ist die Oxidschicht 41 noch dick genug, um die darunterliegende Oberfläche der polykristallinen Siliciumschicht 39 zu passivieren.

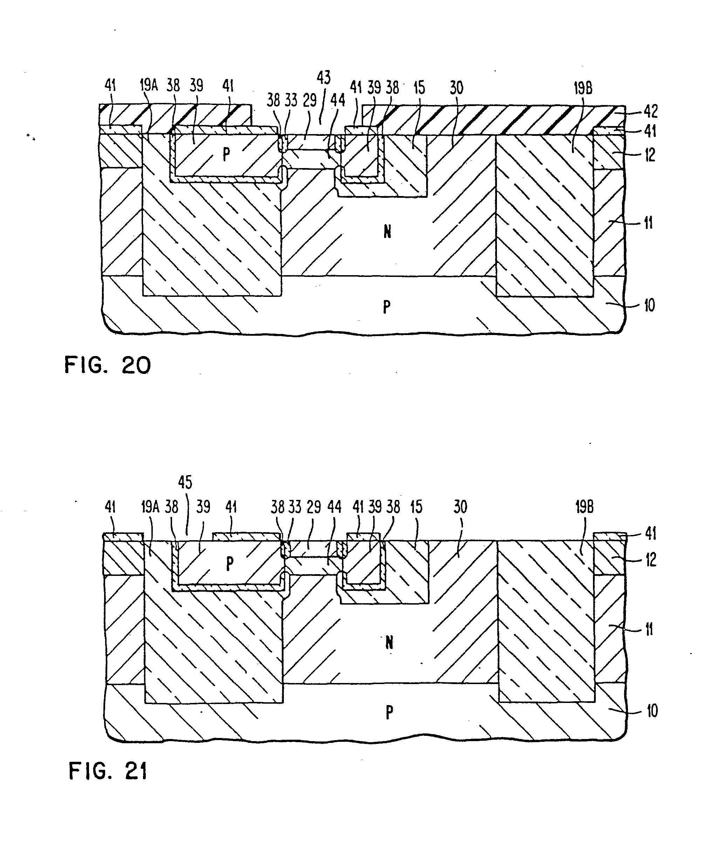

Gemäß Fig. 20, ist eine Photolackschicht 42 aufgetragen, die anschließend exponiert und entwickelt worden ist, um eine Fensteröffnung 43 für einer Borionenimplantation im Bereich der vorgesehenen Basiszone 44 vorzunehmen. Diese Implantation wird z.B. mit einer Interensität in der Größenordnung von 40 keV mit einer Dosierung im Bereich zwischen 0,5 bis $2,0\times10^{13}$ Ionen pro cm$^2$ durchgeführt. Nach Anschluß des Implantationsvorgangs wird die Photolackschicht 42 wieder abgezogen. Die erhaltene Struktur wird auf 900°C aufgeheizt, um die implantierten Atome zu aktivieren.

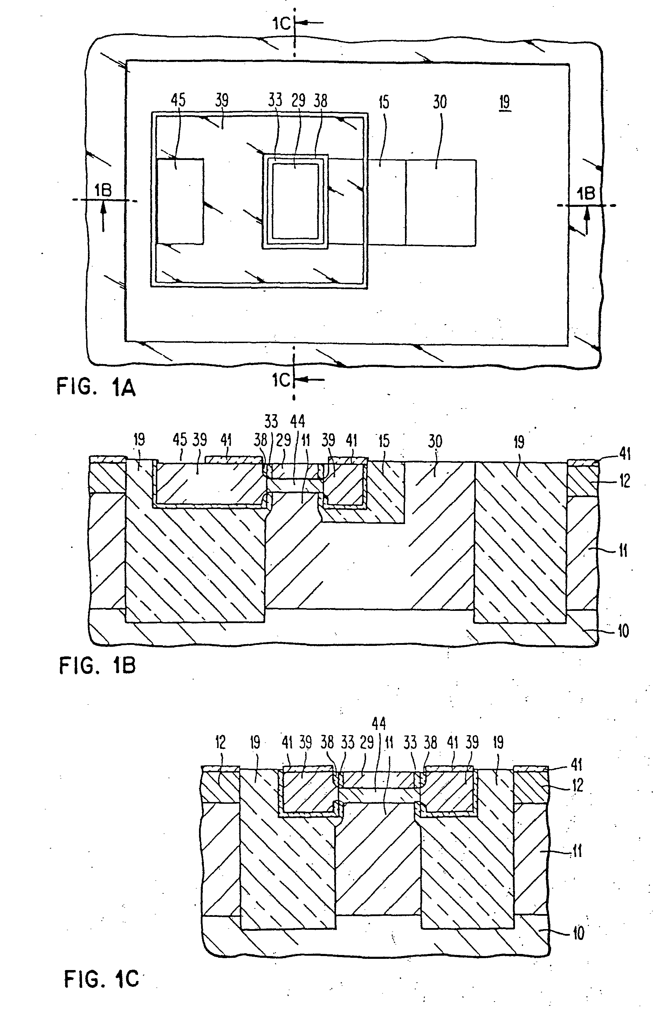

Wie Fig. 21 zeigt, ist eine Anschlußöffnung 45 für die polykristalline P$^+$-Siliciumschicht 39 mit Hilfe eines Lithographie- und Ätzverfahrens eingebracht. Die so erhaltene Struktur ist nun soweit fertiggestellt, daß eine Leitungsmetallisierung aufgebracht werden kann, um den so erhaltenen Transistor mit anderen Transistoren bzw. Schaltungs- oder Halbleiterbauelementen oder passiven Bauelementen auf dem gleichen Halbleitersubstrat 10 zu verbinden. Den Fign. 1A—1C ist die Gesamtstruktur des erfindungsgemäßen Schaltungs- oder Halbleiterbauelement zu entnehmen, indem nämlich dort außer dem mit Fig. 21 übereinstimmenden Längsquerschnitt Fig. 1B auch noch die Draufsicht (Fig. 1A) und der Breitenquerschnitt (Fig. 1C) gebracht sind. Aus der Draufsicht nach Fig. 1A läßt sich entnehmen, daß der tiefreichende Isolationsgraben 19 rahmenförmig das Schaltungs- oder Bauelement umgibt. Weiterhin ist ersichtlich, daß zudem noch die polykristalline Siliciumzone 30, ebenfalls rahmenförmig, den durch den Emitter 29 in seiner Lage definierten Transistor in sich geschlossen umgibt. Auf den Flächenbereich 45 der polykristallinen Siliciumzone 39 und auf die Kollektoranschlußzone 30, die mit dem vergrabenen Kollektor 11 des Transistors in Verbindung steht, werden Metallisierungen ebenso aufgebracht wie auf die Emitterzone 29.

Der Fig. 1A sowie der den Breitenquerschnitt der Struktur darstellenden Fig. 1C, ist zu entnehmen, daß die in sich geschlossene polykristalline Siliciumzone 39 vollständig bis auf ihre freie Oberfläche in den Siliciumdioxidgräben eingebettet ist. Dabei stellt der flachliegende Siliciumdioxidrahmen 15 gewissermaßen einen Verbindungssteg zwischen den längsverlaufenden Seiten des Isolationsgrabens 19 dar.

Die Doppelisolation aus Siliciumdioxid und Siliciumnitrid gewährleistet eine wirksame Isolation sowohl der Emitterzone 29 und des Kollektors 11 als auch der Emitter- und Kollektorübergänge gegenüber der polykristallinen Siliciumzone 39. Dadurch, daß der tiefreichende Isolationsgraben bis in das P-leitende Halbleitersubstrat reicht, sind somit sowohl schädliche äußere als auch innere Einflüsse auf ein Minimum herabgesetzt.

## Patentansprüche

1. Als bipolarer Transistor auf einem Halbleitersubstrat (10) ausgebildetes selbstjustiertes Schaltungs- oder Bauelement mit sich zumindest teilweise in einer über dem Halbleitersubstrat (10) sehr flach liegenden Epitaxieschicht (12) unterhalb einer Basiszone (44) erstreckendem, vergrabenem Kollektor (11) und mit oberhalb der Basiszone (44) eingebrachter Emitterzone (29), deren obere Halbleitergrenzfläche zusammen mit der der Epitaxieschicht (12) in einer Ebene liegt, dadurch gekennzeichnet, daß sowohl der sich im wesentlichen planar erstreckende Emitterübergang als auch der unter gleichmäßigem Abstand unmittelbar darunterliegende, sich im wesentlichen ebenfalls planar erstrechende Kollektorübergang eine Fläche in der Größenordnung von etwa 1 µm$^2$ aufweist.

2. Anordnung nach Anspruch 1, dadurch gekennzeichnet, daß eine polykristalline Siliciumzone (39) von relativ hoher Leitfähigkeit die Emitterzone (29), die Kollektorzone (11) und die Basiszone (44), letzere im gesamten Bereich der Umfangsfläche kontaktierend umgibt, wobei Isolationsschichten (33, 38) diese polykristalline Siliciumzone (39) gegenüber der Emitterzone (29), dem Emitterübergang, der Kollektorzone (11) und dem Kollektorübergang elektrisch isolieren.

3. Anordnung nach de Ansprüchen 1 und 2, dadurch gekennzeichnet, daß die dielektrische Isolation zwischen der polykristallinen Siliciumzone (39) und den betreffenden Transistorzonen (29, 11) sowie den PN-Übergängen aus einer Doppelschicht, bestehend aus Siliciumdioxid (33) und Siliciumnitrid (38), ausgebildet ist.

4. Anordnung nach den Ansprüchen 1 bis 3, dadurch gekennzeichnet, daß unter Verwenden einer aus Silicium bestehenden Halbleiterstruktur die die Emitterzone (29) und Basiszone (44) umgebende, entartet dotierte polykristalline P-Siliciumzone (39) mit einer deren obere Oberfläche freilassenden Siliciumnitridschicht (38) umgeben ist, die zusätzlich im Bereich der Basiszonen-Umfangsfläche einen umlaufenden Öffnungsschlitz zur Kontaktierung der polykristallinen Siliciumzone (39) mit der P-Basiszone (44) am gesamten Umfang aufweist, daß die polykristalline Siliciumzone (39) auf einer Seite zum Anbringen eines Basisanschlusses lateral erweitert ist und daß das Schaltungs- oder Bauelement von einem bis in das P-Halbleitersubstrat (10) reichenden, aus Siliciumdioxid bestehenden Isolationsgrabenrahmen (19) umgeben ist, in den auf der genannten einen Seite die lateral erweiterte mit der Siliciumnitridschicht (38) umgebene polykristalline Siliciumzone (39) eingebettet ist und der auf der gegenüberliegenden Seite zum Anbringen einer Kollektormetallisierung auf einem entsprechenden Bereich der freien Halbleiteroberfläche einen Abstand von der polykristallinen Siliciumzone (39) hat, die an dieser Stelle mit ihrem Siliciumnitridschichtüberzug von einer in der in den vergrabenen Kollektor (11) übergehenden Kollektoranschlußzone (30) flachliegenden Isolations bettang aus Siliciumdioxid (15) umgeben ist, wobei die Kollektorzone (11) vom entgegengesetzten Leitfähigkeitstyp gegenüber dem des Halbleitersubstrats (10) ist.

**0 029 900**

5. Verfahren zur Herstellung eines selbstjustierten Schaltungs- oder Bauelement nach den Ansprüchen 1 bis 4, gekennzeichnet durch die folgenden Verfahrensschritte:

— Einbringen einer zur Bereitstellung der vergrabenen Kollektorzone dienenden Zone eines entgegengesetzte, zweiten Leitfähigkeitstyps (11) in das Hlableitersubstrat (10), eines ersten Leitfähigkeitstyps,
— Aufbringen einer Epitaxieschicht des gleichen Leitfähigkeitstyps wie die darunterliegende, zur Bereitstellung des Kollektors dienende Halbleiterzone (11),
— Aufbringen einer Oxidschicht auf die freie Oberfläche der Epitaxieschicht (12),
— Aufbringen einer Photolackschicht (14) aus die freie Oberfläche der Oxidschicht (13),
— Anwenden eines Photoätzverfahrens zum Einbringen einer Fensteröffnung (15) in die Photolackschicht (14) sowie in die Oxidschicht (13) an der Stelle der vorgesehenen flachliegenden Isolations bettung (15),
— Anwenden eines reaktiven Ionenätzverfahrens zum Abtragen der in der Fensteröffnung (15) freiliegenden Epitaxieschicht (12), sowie einer Vertiefung im darunterliegenden Bereich der Halbleiterzone (11),
— Niederschlagen einer Oxidschicht (16) auf die sich ergebende Strukturoberfläche,
— Aufbringen einer Photolackschicht (17) auf die Oxidschicht (16),
— Einbringen von Fensteröffnungen (18A, 18B) in die Photolackschicht (17) und die Oxidschicht (16),
— Abtragen der Photolackschicht (17),
— unter Anwenden der Oxidschicht als Maske, Durchführen eines reaktiven Ionenätzverfahrens zum Ausheben des tiefreichenden Isolationsgrabenrahmens (19), indem der Ätzvorgang abgebrochen wird, sobald eine entsprechende Vertiefung im Halbleitersubstrat (10) eingebracht ist,
— Abtragen der Oxidschicht (16),
— Auftragen einer dünnen Oxidschicht (20) auf die sich ergebende Strukturoberfläche,
— Auftragen einer Oxid-Dickschicht zur Auffüllung sowohl des flachliegenden Isolationsgrabens (15) als auch des tiefreichenden Isolationsgrabenrahmens (19) unter Erzielen einer im wesentlichen ebenen freiliegenden Strukturoberfläche,
— Auftragen einer Abdeckungsphotolackschicht (22) auf die freie Oberfläche der Oxiddickschicht (21),
— Reaktives Ionenätzen über die Oberfläche der so erhaltenen Struktur bis sum Erreichen der Epitaxieschichtoberfläche,
— Auftragen einer Photolackschicht (23) zum Einbringen einer Fensteröffnung (24) im Bereich der vorgesehenen Kollektoranschlußzone (30),
— Einbringen von Atomen des zweiten Leitfähigkeitstyps über diese Fensteröffnung (24) in den darunterliegenden Bereich der Epitaxieschicht (12), zum Herbeiführen einer Durchreichzone (25) zur Kollektorzone (11),
— Abtragen der Photolackschicht (23),
— Auftragen einer neuen Photolackshicht (26) auf die freigelegte Strukturoberfla8che,
— Einbringen von Fensteröffnungen (27, 28) in die Photolackschicht (26) an der für den Transistor vorgesehenen Stelle der Struktur sowie an der für den Kollektoranschluß vorgesehenen Stelle der Kollektoranschlußzone,
— Einbringen von Fremdatomen eines zweiten Leitfähigkeitstyps über diese Fensteröffnungen (27, 28) um sowohl die Emitterzone (29) als auch die Kollektoranschlußzone (30) bereit zu stellen,
— Abtragen der Photolackschicht (26),
— Auftragen einer neuen Photolackschicht (31),
— Einbringen einer Fensteröffnung (32) in die Photolackschicht (31) an der Stelle der Struktur, an der die polykristalline Siliciumzone (39) vorgesehen ist,
— Anwenden eine Ätzverfahrens mit hoher Ätzrate für Siliciumdioxid im Vergleich zu der für Silicium indem sowohl ein entsprechenden Teil der Füllung des flachliegenden Isolationsbettung (15) als auch ein entsprechender Teil der Füllung des tiefreichenden Isolationsgrabenrahmens (19) abgetragen wird,
— Abtragen der Photolackschicht (31),
— thermisches Oxidieren der freigelegten Oberflächenbereiche der Struktur bei relativ neidriger Temperatur, so daß sich erste Oxidickschichten (33, 34 und 35) über der Emitterzone (29), am Kollektor (11) und über der Kollektoranschlußzone (30) sowie Oxiddünnschichten (36 und 37) an der leicht dotierten Seitenwandung des Basisanschlusses und des freigelegten Oberflächenbereichs der Epitaxieschicht (12) ausbilden.

6. Verfahren nach Anspruch 5 gekennzeichnet durch folgende weiter Verfahrensschritte:

— Aussetzen der sich ergebenden Substratoberfläche einer chemischen Ätzlösung auf gepufferter Fluor-Wasserstofflösung derart, daß die Oxiddünnschichten (36 und 37) insgesamt abgetragen und die Oxiddickschichten (33, 34 und 35) lediglich geringfügig verdünnt werden,
— Auftragen einer Siliciumnitridschicht (38) auf die sich ergebende Strukturoberfläche,
— Umwandeln derjenigen Teile der Siliciumnitridschicht, (38) die auf freigelegten Siliciumbereichen (12, 36) niedergeschlagen sind, in anodisches Siliciumdioxid,
— Aussetzen der sich ergebenden Strukturoberfläche einer chemischen Ätzlösung, bestehend aus gepufferter Fluor-Wasserstofflösung, um so die zwar gebildete anodische Siliciumdioxidschicht über den darunterliegenden Siliciumbereichen (12, 36) abzutragen.

9

**0 029 900**

7. Verfahren nach Anspruch 5 und 6 weiterhin gekennzeichnet durch folgende Verfahrensschritte:

— Auftragen einer polykristallinen Siliciumschicht (39), enthaltend Fremdatome vom ersten Leitfähigkeitstyp über die sich ergebende Strukturoberfläche in zweckmäßiger Dicke,
— Auftragen einer Abdeckphotolackschicht (40) auf die freie Oberfläche der polykristallinen Siliciumschicht (39), um die Strukturoberfläche einzuebnen, und
— Anwenden eines reaktiven Ionenätzverfahrens, um die Photolackschicht (40) sowie den oberen Teil der polykristallinen Siliciumschicht (39) bis zum Erreichen der Oberfläche der Siliciumnitridschicht (38) abzutragen.

8. Verfahren nach den Ansprüchen 5 bis 7 weiterhin gekennzeichnet durch folgende Verfahrensschritte:

— Aufwachsenlassen einer zweiten Oxiddickschicht (41) auf die sich ergebende Oberfläche der Struktur, nämlich den Oberflächenbereichen der polykristallinen Siliciumzone (39) und der Epitaxieschicht (12),
— Abtragen freigelegter Bereiche der Siliciumnitridschicht (38),
— Abtragen freigelegter Bereiche der ersten Oxidsdickschicht (33, 35) die die Emitterzone (29) bzw. die Kollektoranschlußzone (30) abdecken,
— Auftragen einer Photolackschicht (42) mit einer Fensteröffnung (43) an der Stelle der Strukturoberfläche, unterhalb der sich der Transistor befindet, um eine Maske für eine Basiszonen-Implantation zu bilden,
— Implantation von Fremdatomen des ersten Leitfähigkeitstyps sowohl über diese Fensteröffnung (43) als auch über die darunterliegende Emitterzone (29), um die Basiszone (44) hervorzubringen, indem das Maximum der Fremdatomkonzentration hierin unterhalb der Emitterzone (29) zu liegen kommt.

## Revendications

1. Elément de circuit ou composant auto-aligné monté en transistor bipolaire sur un substrat semiconducteur (10), comportant au moins un collecteur (11) enterré, qui s'étend partiellement dans une couche épitaxiale (12) disposée plane au-dessus dudit substrat semiconducteur (10), sous une zone de base (44) et, une zone émetteur (29) implantée au-dessus de ladite zone de base (44), la zone émetteur (29) ayant sa surface d'interface du semiconducteur, disposée de façon plane, commune avec l'interface de ladite couche épitaxiale (12), caractérisée en ce que, aussi bien la jonction émetteur substantiellement plane que la jonction, substantiellement plane, disposée directement sous jacente à la jonction émetteur et avec une même distance que précédemment n, ont une surface d'une épaisseur d'environ 1 $\mu m^2$.

2. Dispositif selon la revendication 1, caractérisé en ce qu'une zone de silicium polycristallin (39) ayant une conductivité relativement élevée est disposée en contact autour de la zone émetteur (29), de la zone collecteur (11) et sur toute la périphérie de la zone de base (44), lesdites couches d'isolation (33, 38) isolant électriquement cette zone de silicium polycristallin (39) de ladite zone émetteur (29), de sa jonction, de la zone collecteur (11) et de sa jonction.

3. Dispositif selon la revendication 1 et 2, caractérisé en ce que ladite isolation diélectrique entre la zone de silicium polycristallin (39) et les zones associées de transistor (29, 11) et les jonctions PN est composée de deux couches, en silice (33) et en nitrure de silicium (38).

4. Dispositif selon les revendications 1 à 3, caractérisé en ce que, dans le cas où on utilise une structure semiconductrice en silicium, la zone de silicium P polycristallin (39) dopée pour être dégénérée qui entoure ladite zone émetteur (29) et ladite zone base (44) est entourée d'une couche de nitrure de silicium (38) dont la surface est découverte, laquelle couche de nitrure de silicium (38) comporte en outre sur la totalité de sa périphérie dans légion de la zone base une fente circulaire pour être en contact avec la zone de silicium polycristallin (39), en ce que ladite zone de silicium polycristallin (39) s'étend latéralement sur un côté de manière à permettre un contact avec la base et, en ce que ledit élément de circuit ou composant est entouré d'un caisson d'isolation (19) en siliciure qui s'étend jusqu'au substrat semiconducteur P (10) dans lequel est encastrée, sur ledit côté, ladite zone de silicium polycristallin (39) s'étendant latéralement, elle-même entourée par ladite couche de nitrure de silicium (38) et que, afin de pouvoir déposer un couche de métallisation collecteur sur la partie correspondante de la surface découverte du semiconducteur, est, sur le côté opposé, située à distance de ladite zone de silicium polycristallin (39), laquelle zone est, à cet endroit où elle est revouverte d'une couche de nitrure de silicium, entourée par un caisson d'isolation en siliciure (15) plan dans la zone de connextion avec la collecteur (30) tout en évitant le collecteur enterré (11), la zone collecteur (11) ayant un type de conductivité opposé à celui du substrat semiconducteur (10).

5. Procédé pour fabriquer un élément de circuit ou un composant selon les revendications 1 à 4, caractérisé par les étapes suivantes:

— Implantation, dans le substrat semiconducteur (10) d'un premier type de conductivité, d'une zone (11) d'un second type de conductivité opposé audit premier type de conductivité, afin de conditionner ladite zone collecteur enterrée,
— Dépôt d'une couche épitaxiale du même type de conductivité que la zone semiconductrice (11) sous-jacente qui conditionne ledit collecteur,

**0 029 900**

— Dépôt d'une couche photosensible (14) sur ladite surface découverte de la couche d'oxide (13),
— Utilisation d'un procédé de photogravure pour pratiquer une fenêtre (15) dans ladite couche photosensible (14) ainsi que dans ladite couche d'oxide (13) à l'endroit du caisson plan (15),
— Utilisation d'un procédé de décapage par ions réactif pour enlever la couche épitaxiale (12) découverte par ladite fenêtre (15) et un évidement situé dans la région sous-jacente de ladite zone semiconductrice (11),
— Dépôt en phase vapeur d'une couche d'oxide (16) sur la surface de la structure obtenue à cette étape du procédé,
— Dépôt d'une couche photosensible (17) sur ladite couche d'oxide (16),
— Ouverture de fenêtres (18A, 18B) dans ladite couche photosensible (17) et dans ladite couche d'oxide (16),
— Enlèvement de ladite couche photosensible (17),
— Application d'un procédé de décapage aux ions réactifs, où on utilise ladite couche d'oxide comme masque, afin de creuser le caisson d'isolation profond (19), ledit procédé de décapage étant interrompu dès qu'on obtient un évidement voulu dans ledit substrat semiconducteur (10),
— Enlèvement de ladite couche d'oxide (16),
— Dépôt d'un mince couche d'oxide (20), sur la surface de la structure obtenue à cette étape du procédé,
— Dépôt d'une couche d'oxide épaisse afin de remplir aussi bien le caisson d'isolation plan (15) que le caisson d'isolation profond (19) pour obtenir une surface exposée généralement plane,
— Dépôt d'une couche photosensible (22) pour recouvrir la surface découverte de ladite couche d'oxide (21),
— Décapage par ions réactifs à la surface de la structure obtenue à cette étape du procédé jusqu'à ce qu'on parvienne à la surface de la couche épitaxiale,
— Dépôt d'une couche photosensible (23) afin de pratiquer une fenêtre (24) dans la région de ladite zone de connexion avec le collecteur (30),
— Introduction d'atomes du second type de conductivité à travers ladite fenêtre (24) dans la région sous-jacente de la couche épitaxiale (12) de façon à former une zone de traversée (25) que atteigne ladite zone collecteur (11),
— Enlèvement de ladite couche photosensible (23),
— Dépôt d'une nouvelle couche photosensible (26) à la surface découverte de ladite structure,
— Ouverture de fenêtres (27, 28) dans ladite couche photosensible (26) à l'endroit prévu pour le transistor ainsi qu'à un endroit, dans ladite zone de connextion avec le collecteur, prévu pour établir le contact,
— Introduction d'atomes étrangers d'un second type de conductivité à travers lesdites fenêtres (27, 28) afin de conditionner à la fois la zone émetteur (29) et la zone de connexion avec le collecteur (30),
— Enlèvement de ladite couche photosensible (26),
— Dépôt d'une nouvelle couche photosensible (31),
— Ouverture d'une fenêtre (32) dans ladite couche photosensible (31) à un endroit dans la structure où est prévue ladite zone de silicium polycristallin (39),
— Utilisation d'un procédé de décapage pour enlever le siliciure à un taux de décapage plus élevé que celui pratiqué pour enlever le silicium où on enlève aussi bien une partie voulue de remplissage du caisson d'isolation plan (15) qu'une partie voulue de remplissage du caisson d'isolation profond (19),
— Enlèvement de ladite couche photosensible (31),
— Oxidation thermique des régions découverte à la surface de ladite structure à une température relativement basse de façon à faire croître des premières couches d'oxide épaisses (33, 34 et 35) au-dessus de la zone émetteur (29), au collecteur (11) et au-dessus de la zone de connexion avec le collecteur (30) ainsi que des couches d'oxide minces (36, 37) sur la paroi latérale légèrement dopée de la connexion avec la base et de la région de surface découverte de ladite couche épitaxiale (12).

6. Procédé selon la revendication 5, caractérisé par les étapes du procédé suivantes:

— Application d'une solution décapante chimique composée de fluorure d'hydrogène tamponné à la surface du substrat obtenu de telle sorte que lesdites couches d'oxide minces (36 et 37) soient enlevées toutes ensemble et que lesdites couches d'oxide épaisses (33, 34 et 35) soient seulement amincies de façon minime,
— Dépôt d'une couche de nitrure de silicium (38) sur la surface de la structure ainsi obtenu,
— Transformation desdites parties de la couche de nitrure de silicium (38) déposées en phase vapeur sur les régions de silicium exposées (12, 36), en siliciure anodique,
— Application à la surface de la structure obtenue d'une solution décapante chimique composée de fluorure d'hydrogène tamponné afin d'enlever la couche de siliciure anodique formée sur les régions de silicium sous-jacentes (12, 36).

7. Procédé selon la revendication 5 et 6, caractérisé en outre par les étapes de procédé suivantes:

— Dépôt d'une couche de silicium polycristallin (39), contenant des atomes étrangers d'un premier type de conductivité à la surface de la structure obtenue, d'une épaisseur appropriée.

11

## 0 029 900

— Dépôt d'une couche photosensible de couverture (40) à la surface de ladite couche de silicium polycristallin (39) afin d'uniformiser la surface de la structure et,

— Utilisation d'un procédé de décapage par ions réactifs afin d'enlever ladite couche photosensible (40) ainsi que la partie supérieure de ladite couche de silicium polycristallin (39) jusqu'à ce qu'on la surface de la couche de nitrure de silicium (38).

8. Procédé selon les revendications 5 à 7, caractérisé en outre par les étapes de procédé suivantes:

— Croissance d'une seconde couche d'oxide épaisse (41) à la surface de la structure obtenue, notamment les régions de surface de la couche de silicium polycristallin (39) et de la couche épitaxiale (12),

— Enlèvement des zones découvertes de la couche de nitrure de silicium (38),

— Enlévement des zones découvertes de la première couche d'oxide (33, 35) qui recouvrent la zone émetteur (29) et la zone de connexion avec le collecteur (30),

— Dépôt d'une couche photosensible (42) comportant une fenêtre (43) à l'endroit de la surface de la structure en-dessous de laquelle se trouve le transistor afin de former un masque pour implanter des zones de base,

— Introduction d'impuretés dudit premier type de conductivité aussi bien au-dessus de cette ouverture (43) qu'au-dessus de la zone émetteur sous-jacente (29) afin de former la zone de base (44), le maximum de la concentration des atomes étrangers étant disposé sur ladite zone émetteur (29).

## Claims

1. Self-adjusted circuit element or component designed as a bipolar transistor on a semiconductor substrate (10) with a buried collector (11) extending at least partly beneath a base region (44) in a very flat epitaxial layer (12) over the semiconductor substrate (10), and with an emitter region (29) provided over the base region (44), the upper semiconductor interface being in one plane with the epitaxial layer (12), characterized in that the substantially planar emitter junction as well as the also substantially planar collector junction which is provided directly beneath and uniformly spaced has an area in the order of approximately 1 $\mu m^2$.

2. Arrangement as claimed in claim 1, characterized in that a polycristalline silicon region (39) of relatively high conductivity encompasses the emitter region (29), the collector region (11) and the base region (44), contacting the latter within the entire range of the circumference, with isolating regions (33, 38) electrically isolating this polycristalline silicon region (39) relative to the emitter region (29), the emitter junction, the collector region (11) and the collector junction.

3. Arrangement as claimed in claims 1 and 2, characterized in that the dielectric isolation between the polycristalline silicon region (39) and the respective transistor regions (29, 11) as well as the pn junctions consists of a double layer composed of silicon dioxide (33) and silicon nitride (38).

4. Arrangement as claimed in any one of claims 1 to 3, characterized in that using a silicon semiconductor structure the polycristalline p silicon region (39) with degenerate impurity concentration and surrounding the emitter region (29) and base region (44) is surrounded with a silicon nitride layer (38) not covering the upper surface of the silicon region (39), said silicon nitride layer (38) additionally having, within the area of the base region circumferential surface, a through-going slot for contacting the polycristalline silicon region (39) with the p base regin (44) on the entire circumference, that the polycristalline silicon region (39) is laterally expanded on one side to provide a base connection, and that the circuit element or component is surrounded by an isolation trench frame (19) consisting of silicon dioxide and reaching into the p semiconductor substrate (10), with the laterally expanded polycristalline silicon region (39) surrounded by the silicon nitride layer (38) being embedded in said frame, and said frame being distanced on the opposite side for providing a collector metallization on a corresponding region of the free semiconductor surface, from the polycristalline silicon region (39) which there, with its silicon nitride coating, is surrounded by an isolation bedding of silicon dioxide (15) in a flat collector contact region (30) reaching into the buried collector (11), the collector region (11) being of a conductivity type opposite to that of the semiconductor substrate (10).

5. Method of making a self-adjusted circuit element or component as claimed in claims 1 to 4, characterized by the following process steps:

— introducing a region for providing the buried collector region, of an opposite second conductivity type (11) into the semiconductor substrate (10) of a first conductivity type,

— depositing an epitaxial layer of the same conductivity type as the semiconductor region (11) provided therebeneath and serving for providing the collector,

— depositing an oxide layer on the free surface of the epitaxial layer (12),

— depositing a photoresist layer (14) on the free surface of the oxide layer (13) utilizing a photoetching process for opening a window (15) in the resist layer (14) and in the oxide layer (13) in the location of the flat isolation bedding (15),

— utilizing a reactive ion etching process to remove the epitaxial layer (12) in the window (15), as well as the recess in the area therebeneath of the semiconductor region (11),

12

— depositing an oxide layer (16) on the thus obtained structure surface,

— depositing a photoresist layer (17) on the oxide layer (16),

— opening windows (18A, 18B) in the photoresist layer (17) and the oxide layer (16),

— removing the photoresist layer (17),

— using the oxide layer as a mask,

— utilizing a reactive ion etching process to provide the deep isolation trench frame (19) by interrupting the etching process as soon as a corresponding recess has been made in the semiconductor substrate (10),

— removing the oxide layer (16),

— depositing a thin oxide layer (20) on the thus obtained structure surface,

— depositing a thick oxide layer to fill the shallow isolation trench (15) as well as the deep isolation trench frame (19), thus obtaining a substantially planar exposed structure surface,

— depositing a photoresist cover layer (22) on the exposed surface of the thick oxide layer (21),

— reactive ion etching over the surface of the thus obtained structure to the surface of the epitaxial layer,

— depositing a photoresist layer (23) for opening a window (24) within the provided collector contact region (30),

— introducing atoms of the second conductivity type over this window (24) into the area therebeneath of the epitaxial layer (12) to form a reach-through region (25) to the collector region (11),

— removing the photoresist layer (23),

— depositing a new photoresist layer (26) on the exposed structure surface,

— opening windows (27, 28) into the photoresist layer (26) in that part of the structure which is provided for the transistor, as well as in that part of the collector contact region provided for the collector contact,

— introducing impurities of a second conductivity type via these windows (27, 28) to provide the emitter region (29) as well as the collector contact region (30),

— removing the photoresist layer (26),

— depositing a new photoresist layer (31),

— opening a window (32) into the photoresist layer (31) in that part of the structure provided for the polycristalline silicon region (39),

— utilizing an etching process with a high etching rate for silicon dioxide compared with that used for silicon, by removing a corresponding portion of the filling of the flat isolation bedding (15) as well as a corresponding portion of the filling of the deep isolation trench frame (19),

— removing the photoresist layer (31),

— thermally oxidizing of the exposed surface regions of the structure with a relatively low temperature so that first thick oxide layers (33, 34 and 35) form over the emitter region (29), at the collector (11) and over the collector contact region (30), as well as thin oxide layers (26 and 37) at the lightly doped side wall of the base contact and of the exposed surface region of the epitaxial layer (12).

6. Method as claimed in claim 5, characterized by the following further process steps:

— subjecting the thus obtained substrate surface to a chemical etching solution of buffered hydrogen fluoride in such a manner that the thin oxide layers (36 and 37) are removed in total, and the thick oxide layers (33, 34 and 35) are merely slightly reduced,

— depositing a silicon nitride layer (38) on the thus obtained surface of the structure,

— converting those portions of the silicon nitride layer (38) deposited on exposed silicon regions (12, 36) into anodic silicon dioxide,

— subjecting the thus obtained structure surface to a chemical etching solution consisting of buffered hydrogen fluoride to remove the previously formed anodic silicon dioxide layer over the silicon regions (12, 36) therebeneath.

7. Method as claimed in claims 5 and 6, furthermore characterized by the following process steps:

— depositing a polycristalline silicon layer (39) containing impurities of the first conductivity type over the thus obtained structure surface in a suitable thickness,

— depositing a photoresist cover layer (40) on the exposed surface of the polycristalline silicon layer (39) to planarize the structure surface,

— utilizing a reactive ion etching process to remove the photoresist layer (40) as well as the upper part of the polycristalline silicon layer (39) down to the surface of the silicon nitride layer (38).

8. Method as claimed in any one of claims 5 to 7, furthermore characterized by the following process steps:

— growing a second thick oxide layer (41) on the thus obtained surface of the structure, i.e. the surface regions of the polycristalline silicon region (39) and the epitaxial region (12),

— removal of exposed areas of the silicon nitride layer 38,

— removal of exposed areas of the first thick oxide layer (33, 35) covering the emitter region (29), and the collector contact region (30), respectively,

**0 029 900**

— depositing a photoresist layer (42) with a window (43) in that part of the structure surface beneath which the transistor is provided to form a mask for a base region implantation,

— implanting impurities of the first conductivity type, via these windows (43) as well as via the emitter region (29) therebeneath to provide the base region (44) in that the maximum of the impurity concentration is provided beneath the emitter region (29).

**0 029 900**

FIG. 1A

FIG. 1B

FIG. 1C

1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21